(19) Europäisches Patentamt
European Patent Office
Office européen des brevets

(11) Veröffentlichungsnummer: **0 207 315**
**A2**

(12) # EUROPÄISCHE PATENTANMELDUNG

(21) Anmeldenummer: 86107558.8

(22) Anmeldetag: 04.06.86

(51) Int.Cl.⁴: H 01 L 39/14
H 01 L 39/24

(30) Priorität: 05.07.85 DE 3524082

(43) Veröffentlichungstag der Anmeldung:
07.01.87 Patentblatt 87/2

(84) Benannte Vertragsstaaten:
DE FR GB IT NL

(71) Anmelder: BROWN, BOVERI & CIE Aktiengesellschaft
Kallstadter Strasse 1
D-6800 Mannheim 31(DE)

(71) Anmelder: Kernforschungszentrum Karlsruhe GmbH
Postfach 3640
D-7500 Karlsruhe 1(DE)

(72) Erfinder: Schmaderer, Franz, Dipl.-Ing.
Sciplostrasse 25
D-6831 Plankstadt(DE)

(72) Erfinder: Wahl, Georg Fried, Dr. Dipl.-Phys.
Franz-Liszt-Strasse 9
D-6904 Eppelheim(DE)

(72) Erfinder: Dustmann, Cord-Heinrich, Dr. Dipl.-Phys.
Diemstrasse 10
D-6940 Weinheim(DE)

(72) Erfinder: Fitzer, Erich, Prof. Dr.
Haydnplatz 5
D-7500 Karlsruhe(DE)

(72) Erfinder: Brennfleck, Karl, Dr.
Im Hohen Grund 6
D-7500 Karlsruhe 41(DE)

(72) Erfinder: Dietrich, Manfred, Dr. Dipl.-Phys.
Trierer Strasse 33
D-7500 Karlsruhe 21(DE)

(74) Vertreter: Kempe, Wolfgang, Dr. et al,
c/o Brown, Boveri & Cie AG Postfach 351
D-6800 Mannheim 1(DE)

(54) **Supraleitende Faser und Verfahren zu deren Herstellung.**

(57) Das Faserbündel ist aus einer Vielzahl von Trägerfasern (11) aufgebaut, die jede durch eine Basisschicht (12) und eine Vielzahl von supraleitenden Schichten (13) abgedeckt ist. Die supraleitenden Schichten (13) sind durch Trennschichten (14) aus hochschmelzendem Metall oder hochschmelzender Metallegierung voneinander getrennt. Durch diesen Schichtaufbau lassen sich dünne supraleitende Schichten (13) mit sehr feinkörnigem supraleitenden Material realisieren. Die einzelnen Schichten werden durch chemische Abscheidung aus der Gasphase aufgetragen. Ein bevorzugtes Material für die Basisschicht und die Trennschichtem ist Wolfram.

EP 0 207 315 A2

./...

Croydon Printing Company Ltd.

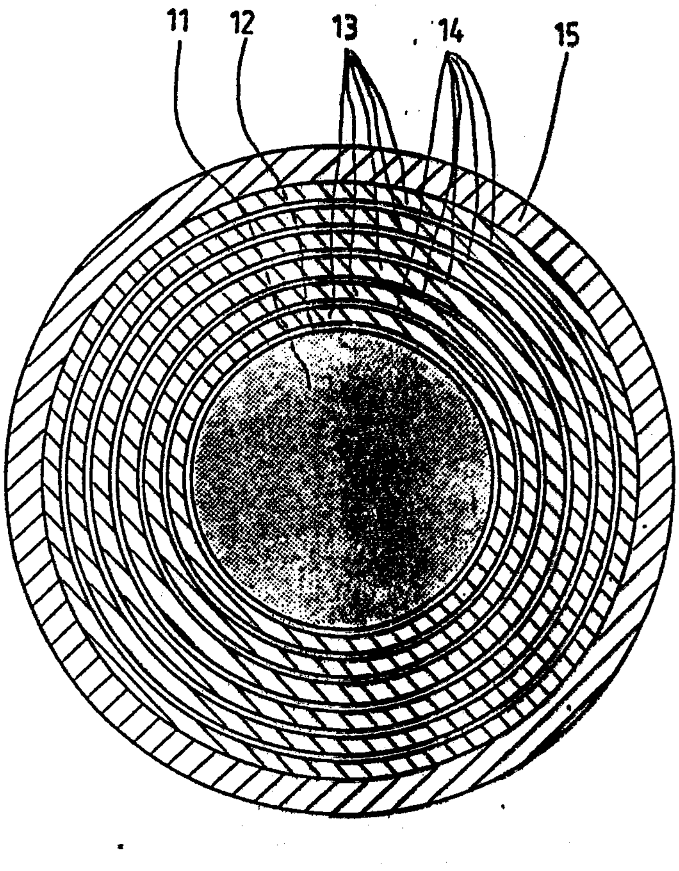


Fig. 1

BROWN,BOVERI & CIE, Aktiengesellschaft
Mannheim
und
KERNFORSCHUNGSZENTRUM Karlsruhe GmbH

03. Juli 1985

Mp.Nr. 582/85 ZPT/P2-La/Fo

Supraleitende Faser und Verfahren zu deren Herstellung

Die Erfindung betrifft eine supraleitende Faser eines supraleitenden Faserbündels, bei welcher die Mantelfläche einer Trägerfaser von einer supraleitenden Schicht, insbesondere aus Niobcarbonitrid oder Nioboxycarbonitrid, umhüllt ist. Die Erfindung betrifft ferner ein Verfahren zur Herstellung supraleitender Faserbündel.

Bei der Weiterentwicklung der Energietechnik im Hinblick auf die Kernfusion und auf supraleitende Generatoren, der Verkehrstechnik (Magnetschwebebahn), der Umwelttechnik (Kohlenentschwefelung) und der Hochenergiephysik werden Starkstromfeldmagnete benötigt, die unter wirtschaftlichen Gesichtspunkten nur auf Supraleiterbasis hergestellt werden können.

Insbesondere für derartige Anwendungen wurden geeignete, einen hohen Elastizitätsmodul aufweisende Trägerfasern (z.B. C,B,Stahl) mit supraleitendem Material beschichtet

und zu Faserbündeln, die eine beliebige Anzahl von Einzelfasern enthalten, zusammengefaßt. Die Trägerfasern dienen als zugfeste Matrix und als Substrat für den Auftrag der supraleitenden Schicht. Als aussichtsreiches Supraleitungsmaterial sind z.B. Niobcarbonitride Nb(C,N) und Nioboxycarbonitride der allgemeinen Formel $NbC_xN_yO_z$ (x+ y + z kleiner/gleich 1) bekanntgeworden. Derartige Niobverbindungen zeichnen sich durch hohe kritische Temperaturen, hohe kritische Magnetfelder und hohe kritische Stromdichten aus. Sie lassen sich durch ein chemisches Gasabscheideverfahren (CVD-Chemical Vapor Deposition), bei dem das Niob durch Reaktion von $NbCl_5$ mit $H_2$ in Gegenwart von kohlenstoff- und stickstoffhaltigen Gasen als dünner Film abgeschieden wird, auf die Trägerfasern aufbringen. Der CVD-Prozeß wird dabei entweder einstufig (gleichzeitige Nb-Abscheidung und Carbonitrierung) oder zweistufig (Nb-Abscheidung und Carbonitrierung zeitlich aufeinanderfolgend) durchgeführt.

Durch die DE-AS 28 56 885 und die Veröffentlichung "Chemical Vapor Deposition of Superconducting Niobium Carbonitride Films on Carbon Fibres", K. Brennfleck, M. Dietrich, E. Fitzer, D. Kehr, Proc. of CVD - 7th, Int. Conf., 300-314, The Electrochem. Soc., Princeton, NY, (1979) ist ein derartiges zweistufiges CVD-Verfahren bekanntgeworden. Ferner sind durch die EP 0102489 A2 sowie durch die Veröffentlichung "CVD Processing of Carbon Fiber Superconductors", M. Dietrich, C.-H. Dustmann, F. Schmaderer, G. Wahl, Presented on the Applied Superconductivity Conference, 1982, Knoxville, Paper MB 2 weitere verbesserte Verfahren bekanntgeworden, die zur Herstellung von supraleitenden Faserbündeln geeignet sind. Nach diesen verbesserten Verfahren hergestellte supraleitende Faserbündel weisen eine homogene Beschichtung der einzelnen Fasern des Faserbündels auf. Ihre supraleitenden Schichten sind sehr feinkörnig, so daß

sich wegen der damit verbundenen Verminderung der freien Weglänge der Leitungselektronen hohe kritische Magnetfelder und hohe kritische Stromdichten einstellen.

Es hat sich jedoch gezeigt, daß die Korndurchmesser der supraleitenden Kristalle mit zunehmender Dicke der supraleitenden Schicht zunehmen. Das führt dazu, daß bei Schichtdicken über ca. 100 nm die kritische Magnetfeldstärke und die kritische Stromdichte abnehmen. Andererseits lassen geringe Schichtdicken wegen ihres vergleichsweise kleinen Querschnittes nur einen geringen Gesamtstrom zu, so daß für eine ausreichende Stromtragfähigkeit eines supraleitenden Faserbündels die Anzahl der Fasern entsprechend hoch gewählt werden muß. Die Gesamtstromdichte des Faserbündels kann durch die Erhöhung der Faserzahl jedoch nicht gesteigert werden.

Der Erfindung liegt die Aufgabe zugrunde, supraleitende Fasern der eingangs genannten Art sowie Verfahren zu deren Herstellung anzugeben, die hohe Werte für die kritische Magnetfeldstärke und die kritische Stromdichte aufweisen und durch die sich Faserbündel mit hoher Gesamtstromdichte ergeben.

Diese Aufgabe wird erfindungsgemäß dadurch gelöst, daß die Trägerfasern alternierend mit Schichten aus supraleitendem Material und Trennschichten aus hochschmelzendem Metall oder hochschmelzender Metallegierung beschichtet sind.

Die Trennschichten wirken als Barrierematerial. Sie ermöglichen die Ausbildung dünner supraleitender Schichten mit feinem Korngefüge, wobei übereinanderliegende supraleitende Schichten über die zwischen ihnen liegende Trennschicht leitfähig miteinander verbunden sind. Die erfindungsgemäße Faser weist somit eine realativ dicke

Gesamtbeschichtung mit sehr feinkörnigem supraleitenden Material auf, so daß eine hohe kritische Feldstärke und eine hohe Gesamtstromdichte des Faserbündels erreichbar sind.

Hochschmelzende Metalle und Metallegierungen sind geeignete Trennschichtmaterialien, da sie hohe Diffusionskonstanten aufweisen, als Haftvermittler dienen und die supraleitenden Schichten leitfähig miteinander verbinden. Die Wahl der Anzahl der Trennschichten richtet sich unter anderem nach dem Durchmesser der Trägerfaser und der geforderten kritischen Gesamtstromdichte (critical overall current density) des supraleitenden Faserbündels.

Nicht alle Trägerfasermaterialien lassen sich aufgrund der unterschiedlichen Oberflächenbeschaffenheit ohne weiteres mit supraleitendem Material (z.B. Niobcarbonitrid) beschichten. So läßt sich z.B. eine hochzugfeste Kohlenstoffaser, die eine gute Oberflächenaktivität aufweist, mittels CVD relativ gut mit Niobcarbontrid beschichten, während die homogene Beschichtung von Hochmodulfasern (graphitierte Kohlenstoffaser mit kristalliner Struktur, die wegen ihrer günstigen pysikalischen Eigenschaften, wie E-Modul und Bruchdehnung als Trägerfasermaterial besonders geeignet sind) erhebliche Schwierigkeiten bereitet. Um eine weitgehende Unabhängigkeit vom Trägerfasertyp zu erreichen, schlägt eine vorteilhafte Ausgestaltung der Erfindung vor, daß die Trägerfaser mit einer Basisschicht aus hochschmelzendem Metall oder hochschmelzender Metallegierung abgedeckt und auf der Basisschicht der Mehrschichtaufbau aus supraleitenden Schichten und Trennschichten aufgebracht ist. Hierdurch ist ein Faserschutz gegeben, der die Trägerfaser bei der weiteren Beschichtung vor chemischen Attacken (Methanbildung) schützt.

Supraleitende Fasern mit einer die Trägerfaser abdeckenden Basisschicht sind schon aus der DE-PS 33 19 524 bekanntgeworden. Dort wurden jedoch Basisschichtmaterialien aus Carbiden oder Oxyden beschrieben, ohne daß auf einen sich hieran anschließenden Mehrschichtaufbau hingewiesen wurde.

Als besonders geeignetes Material für die Basisschicht und/oder die Trennschichten schlägt die Erfindung Wolfram vor. Das durch ein CVD-Verfahren aufgebrachte Wolfram haftet auf allen Kohlenstoffasertypen gleich gut. Da die Diffusionskonstante des Wolframs bezüglich Wasserstoff und Kohlenstoff gering ist, ist Wolfram als Diffusionsbarriere besonders gut geeignet, so daß Kohlenstoffwasserbildung vermieden wird, die zum Ablösen der Niobcarbonitridschicht von der Trägerfaser führen kann. Die Unterschiede der Oberflächeneigenschaften (z.B. zwischen hochzugfesten Kohlenstoffasern und Hochmodulfasern) werden durch die Wolframdeckschicht aufgehoben.

Die Wolframoberfläche der Basisschicht und der Trennschicht hat günstige Keimbildungseigenschaften (nucleation conditions) für Niobcarbonitrid oder Nioboxycarbonitrid, so daß sie die Bildung eines feinen Korngefüges der supraleitenden Schicht begünstigt.

Weitere für die Basisschicht oder Trennschicht besonders geeignete Materialien sind Tantal und Titanverbindungen wie Titannitrid TiN und Titancarbid TiC. Ferner kann die Basisschicht bevorzugt aus Siliziumcarbid SiC oder Wolframcarbid $W_2C$ bestehen.

Die Schichtdicke der Basisschicht und der Zwischenschicht ist so bemessen, daß sie einerseits ausreicht, um eine geschlossene Schicht zu bilden und andererseits

möglichst gering ist, so daß sie wenig zum Gesamtdurchmesser der supraleitenden Faser beiträgt. Vorzugsweise liegt die Schichtdicke zwischen 5 und 20 nm. Als günstiger Wert hat sich 10 nm herausgestellt. Die Schichtdicke der Basisschicht kann auch etwas dicker gewählt werden, um einen zuverlässigen Trägerfaserschutz zu bilden.

Zur Herstellung der beschriebenen erfindungsgemäßen supraleitenden Fasern schlägt die Erfindung eine Weiterentwicklung eines Verfahrens vor, bei dem die supraleitende Beschichtung der Trägerfasern durch chemische Abscheidung aus der Gasphase, insbesondere durch Reaktion von Niobchlorid, Kohlenstoff- und Stickstoffverbindungen, erfolgt. Erfindungsgemäß werden alternierend supraleitende Schichten und Trennschichten auf die Trägerfasern aufgebracht und das hochschmelzende Metall oder die hochschmelzende Metallegierung der Trennschichten werden ebenfalls mit Hilfe der chemischen Abscheidung aus der Gasphase abgeschieden.

Vorzugsweise wird auf der Trägerfaser vor dem Auftrag des Mehrschichtaufbaus eine Basisschicht aus hochschmelzendem Metall oder hochschmelzender Metallegierung mit Hilfe der chemischen Abscheidung aus der Gasphase abgeschieden.

Anhand der Zeichnung, in der Ausführungsbeispiele der Erfindung gezeigt sind, sollen die Erfindung sowie weitere vorteilhafte Ausgestaltungen und Weiterbildungen der Erfindung näher erläutert und beschrieben werden.

Es zeigt:

Fig. 1 eine erfindungsgemäße supraleitende Faser im Querschnitt,

Fig. 2 eine CVD-Apparatur zur Herstellung eines aus

erfindungsgemäßen supraleitenden Fasern bestehenden Faserbündels und

Fig. 3 den Teil der CVD-Apparatur, der dem Auftrag einer Trennschicht dient.

Der stark vergrößerten, schematischen Darstellung des Querschnittes einer erfindungsgemäßen supraleitenden Faser gemäß Fig. 1 ist eine Kohlenstoffaser, die als Trägerfaser 11 dient und auf die verschiedene, konzentrisch angeordnete Schichten aufgetragen sind, entnehmbar. Die Trägerfaser 11 ist eine hochzugfeste Kohlenstoffaser oder eine Hochmodul-Kohlenstoffaser. Als Trägerfaser 11 kann auch eine Faser aus Bor, Stahl oder anderen zugfesten Werkstoffen dienen.

Der Durchmesser der Trägerfaser 11 auf Kohlenstoffbasis liegt bei 0,005 bis 0,007 mm. Auf die Kohlenstoffaser 11 ist eine Basisschicht 12 aus Siliziumcarbid SiC mit einer Schichtdicke zwischen 30 und 80 nm aufgebracht. Die Basisschicht kann jedoch auch aus Wolfram bestehen. Die Basisschicht ist zweckmäßigerweise dicker als eine Trennschicht, da sie vorallem als Diffusionbarriere und damit als Faserschutz dient. Sie schützt die Kohlenstoffaser beim Auftrag der äußeren Schichten im CVD-Prozeß vor chemischen Attacken. Insbesondere wird die Wechselwirkung zwischen Wasserstoff und dem Kohlenstoff der Faser unterbunden, wodurch die Haftung der aufzubringenden Beschichtung wesentlich gesteigert werden kann.

Die Basisschicht 12 ist durch mehrere supraleitende Schichten 13 aus Niobcarbonitrid Nb(C,N) oder Nioboxycarbontrid der allgemeinen Formel $NbC_xN_yO_z$ mit x + y + z kleiner/gleich 1 umgeben. Die supraleitenden Schichten 13 sind jeweils durch Trennschichten 14

aus Wolfram voneinander getrennt. Die Gesamtschichtdicke der supraleitenden Schicht 13 beträgt beispielsweise bei Trägerfasern 11 mit einem Durchmesser von 0,007 mm in etwa 0,001 mm und bei Trägerfasern 11 mit einem Durchmesser von 0,005 mm in etwa 0,0005 mm. Die Schichtdicke einer einzelnen supraleitenden Schicht 13 beträgt vorzugsweise ca. 100 nm, und die Schichtdicke einer Trennschicht 14 liegt zwischen 5 und 20 nm. Der Herstellungsaufwand der supraleitenden Faser nimmt mit der Anzahl der Trennschichten 11 zu. Die Anordnung von zehn Trennschichten ist jedoch noch wirtschaftlich vertretbar.

Der Mehrschichtaufbau auf der Trägerfaser 11 ist durch einen Mantel 15 aus Kupfer bzw. Aluminium abgedeckt, dessen Schichtdicke bei 0,001 mm liegen kann. Dieser Mantel 15 dient der elektrischen Stabilisierung der supraleitenden Faser und trägt im normalleitenden Zustand den elektrischen Strom.

Die Fig. 2 zeigt eine Abscheideapparatur mittels der die gleichzeitige Beschichtung einer Vielzahl von Trägerfasern zur Herstellung eines supraleitenden Faserbündels, welches aus erfindungsgemäßen supraleitenden Einzelfasern besteht, erfolgt.

In einer Abspulkammer 20 befindet sich eine Rohmaterialspule, mit unbeschichteten Trägerfasern 11 (Kohlenstoffaserbündel). Die Trägerfasern 11 werden durch eine nicht dargestellte Fasertransporteinrichtung durch ein Quarzrohr 21, in dem die Beschichtung der Trägerfasern 11 erfolgen, gezogen. Die beschichteten Fasern 22 werden auf eine in der Aufspulkammer 23 befindliche Aufnahmespule aufgehaspelt.

Während seines Transportes von der Abspulkammer 20 zur

Aufspulkammer 23 durchläuft das Faserbündel eine Vielzahl hintereinander angeordneter Öfen 24 bis 31. Die punktierte Linie 32 deutet an, daß weitere, nicht dargestellte Öfen in der Faserbündelbahn liegen können. Zur Einstellung der für die CVD-Prozesse erforderlichen Gasdrücke im Bereich der Öfen befinden sich im Quarzrohr 21 mehrere Gaseinlaßstutzen 33 und Pumpstutzen 34. Ferner weist das Quarzrohr 21 in seinen zwischen den Öfen liegenden Bereichen Drosselstellen 35 auf, durch die sich das Faserbündel ziehen läßt. Die Drosselstellen 35 verhindern einen Druckausgleich im Quarzrohr 21 und ermöglichen das Einstellen unterschiedlicher Gesamt- und Partialdrücke im Bereich jedes Ofens.

Im ersten Ofen 24 werden die Kohlenstoffasern 11, falls notwendig, gereinigt, indem sie in einer Stickstoff- oder Wasserstoffatmosphäre aufgeheizt werden. Die Gaszuflußmenge ($N_2$) in den Gaseinlaßstutzen 33 liegt beispielsweise zwischen 1 und 20 l pro Stunde. Die Ofentemperatur wird auf 600 bis 1000 °C eingestellt.

Im zweiten Ofen 25 erfolgt der Auftrag einer Basisschicht mittels Abscheidung von Siliziumcarbid SiC aus der Gasphase von Siliziummethyltrichlorid $CH_3SiCl_3$. Siliziummethyltrichlorid strömt durch den Gaseinlaßstutzen 33 in das Quarzrohr 21 und zerfällt im Ofen 25 bei einem Partialdruck von etwa 50 mbar und einer Temperatur zwischen 1000 und 1100 °C in Siliziumcarbid SiC und Chlorwasserstoff HCl, wobei sich das Siliziumcarbid auf der gereinigten Kohlenstoffaseroberfläche gleichmäßig abscheidet. Das verbrauchte Gas wird über einen Pumpstutzen 34 abgepumpt, wobei der Gasdruck des Gasgemisches aus Argon und Siliziummethyltrichlorid auf ca. 1000 mbar eingestellt wird.

Im dritten Ofen 26 erfolgt die Niobcarbonitrid- oder

Nioboxycarbonitridabscheidung. Es ist hier lediglich ein Ofen 26 dargestellt, in dem ein einstufiger Prozeß erfolgt. Selbstverständlich können anstelle des Ofens 26 auch zwei hintereinandergeschaltete Öfen für eine zweistufige Abscheidung, wie sie z.B. in der EP 0102489 A2 oder der DE-PS 33 19 524 beschrieben wurden verwendet werden. Die Niobabscheidung kann unter Plasmaaktivierung und/oder Einwirkung eines Ultraschallfeldes erfolgen.

Im vierten Ofen 27 wird mittels eines CVD-Prozesses eine Trennschicht 14 aus Wolfram auf die supraleitende Schicht 13 aufgebracht. Einzelheiten dieses Prozesses werden anhand der Fig. 3 näher erläutert werden. An den vierten Ofen 27 schließen sich weitere Öfen 28 bis 30 an, in denen alternierend weitere supraleitende Schichten 13 und weitere Trennschichten 14 abgeschieden werden.

Im letzten Ofen 31 wird die äußere supraleitende Schicht 13 der Faser mit einer hochleitfähigen Aluminiumschicht 15 überzogen. Dies erfolgt durch einen CVD-Prozeß, bei dem Aluminium aus der Gasphase auf die Fasern abgeschieden wird. Hierzu wird in den Ofen 31 eine metallorganische Verbindung, z.B. Aluminiumtriisobutyl (TIBA) eingeleitet.

Das Quarzrohr 21 (Reaktor) und die Gasversorgung ist durch geeignet angebrachte Strömungswiderstände (Drosselstellen 35) und geeignete Auslegung der Pumpen, die an die Pumpstutzen 34 angeschlossen sind, so konstruiert, daß die Gase in den Öfen 24 bis 31 jeweils in Pfeilrichtung strömen.

Die Fig. 3 zeigt eine Apparatur zum Auftrag einer Wolfram-Trennschicht 14 mittels CVD-Ablagerung. Das Trägerfaserbündel 11 wird in Pfeilrichtung 36 durch ein ge-

schlossenes Quarzrohr 21 transportiert. Das Quarzrohr 21 besteht aus mehreren Abschnitten, die durch Flansche 37 miteinander verbunden sind. Das Quarzrohr 21 verläuft durch einen Ofen 27. Beidseits des Ofens 27 weist das Quarzrohr 21 je eine Drosselstelle 35 auf, die so bemessen ist, daß das Faserbündel hindurchgezogen werden kann, ein Gasaustausch jedoch weitgehend vermieden wird.

Durch einen Gaseinlaßstutzen 38 wird Wolframhexafluorid $WF_6$ und durch einen weiteren Gaseinlaßstutzen 39 Wasserstoff $H_2$ in den Reaktionsraum, d.h. den Teil des Quarzrohres 21, der im Bereich des Ofens 27 liegt, eingeleitet. Die Dosierung der aus Gasflaschen entnommenen Gase $WF_6$ und $H_2$ erfolgt durch Durchflußmengenmesser 40,41. Es werden beispielsweise 12 $lh^{-1}$ Wasserstoff und 3 $lh^{-1}$ Wolframhexafluorid eingeleitet. Über einen Pumpstutzen 34 wird das verbrauchte Reaktionsgas abgepumpt und ein Unterdruck von z.B. 5 mbar im Reaktionsraum eingestellt.

Bei einer durch den Ofen 27 einstellbaren Reaktionstemperatur zwischen 250 und 600 °C (vorzugsweise bei ca. 450 °C) erfolgt die Abscheidung des Wolframs auf der Faser analog der Reaktion

$$WF_6 + 3H_2 \longrightarrow W + 6\ HF.$$

Ansprüche

1. Supraleitende Faser eines supraleitenden Faserbündels, bei welcher die Mantelfläche einer Trägerfaser (11) von einer supraleitenden Schicht (13), insbesondere aus Niobcarbonitrid oder Nioboxycarbonitrid, umhüllt ist, dadurch gekennzeichnet, daß die Trägerfaser (11) alternierend mit Schichten (13) aus supraleitendem Material und Trennschichten (14) aus hochschmelzendem Metall oder hochschmelzender Metallegierung beschichtet ist.

2. Supraleitende Faser nach Anspruch 1, dadurch gekennzeichnet, daß die Trägerfaser (11) mit einer Basisschicht (12) aus hochschmelzendem Metall oder hochschmelzender Metallegierung abgedeckt ist.

3. Supraleitende Faser nach Anspruch 1 oder 2, dadurch gekennzeichnet, daß die Basisschicht (12) und/oder wenigstens eine Trennschicht (14) aus Wolfram besteht.

4. Supraleitende Faser nach einem der Ansprüche 1 bis 3, dadurch gekennzeichnet, daß die Basisschicht (12) und/oder wenigstens eine Trennschicht (14) aus Tantal besteht.

5. Supraleitende Faser nach einem der Ansprüche 1 bis 4, dadurch gekennzeichnet, daß die Basisschicht (12) und/oder wenigstens eine Trennschicht (14) aus einer Titanlegierung, vorzugsweise aus Titannitrid TiN oder Titancarbid TiC besteht.

6. Supraleitende Faser nach einem der Ansprüche 1 bis 5, dadurch gekennzeichnet, daß die Basisschicht (12)

aus Siliziumcarbid SiC oder Wolframcarbid $W_2C$ besteht

7. Supraleitende Faser nach einem der Ansprüche 1 bis 6, dadurch gekennzeichnet, daß die Schichtdicke der Basisschicht (12) und/oder der Trennschicht (14) zwischen 5 und 20 nm liegt.

8. Verfahren zur Herstellung von supraleitenden Fasern nach einem der Ansprüche 1 bis 7, bei dem eine supraleitende Schicht (13), insbesondere aus Niobcarbonitrid oder Nioboxycarbonitrid, mit Hilfe der chemischen Abscheidung aus der Gasphase, insbesondere durch Reaktion von Niobchlorid, Kohlenstoff- und Stickstoffverbindungen, auf der Trägerfaser (11) abgeschieden wird, dadurch gekennzeichnet, daß alternierend supraleitende Schichten (13) und Trennschichten (14) auf die Trägerfaser (11) aufgebracht werden und daß das hochschmelzende Metall oder die hochschmelzende Metallegierung der Trennschichten mit Hilfe der chemischen Abscheidung aus der Gasphase abgeschieden wird.

9. Verfahren nach Anspruch 8, dadurch gekennzeichnet, daß auf die Trägerfaser (11) eine Basisschicht (12) aus hochschmelzendem Metall oder hochschmelzender Metallegierung mit Hilfe der chemischen Abscheidung aus der Gasphase abgeschieden wird und sich hieran der alternierende Mehrschichtaufbau anschließt.

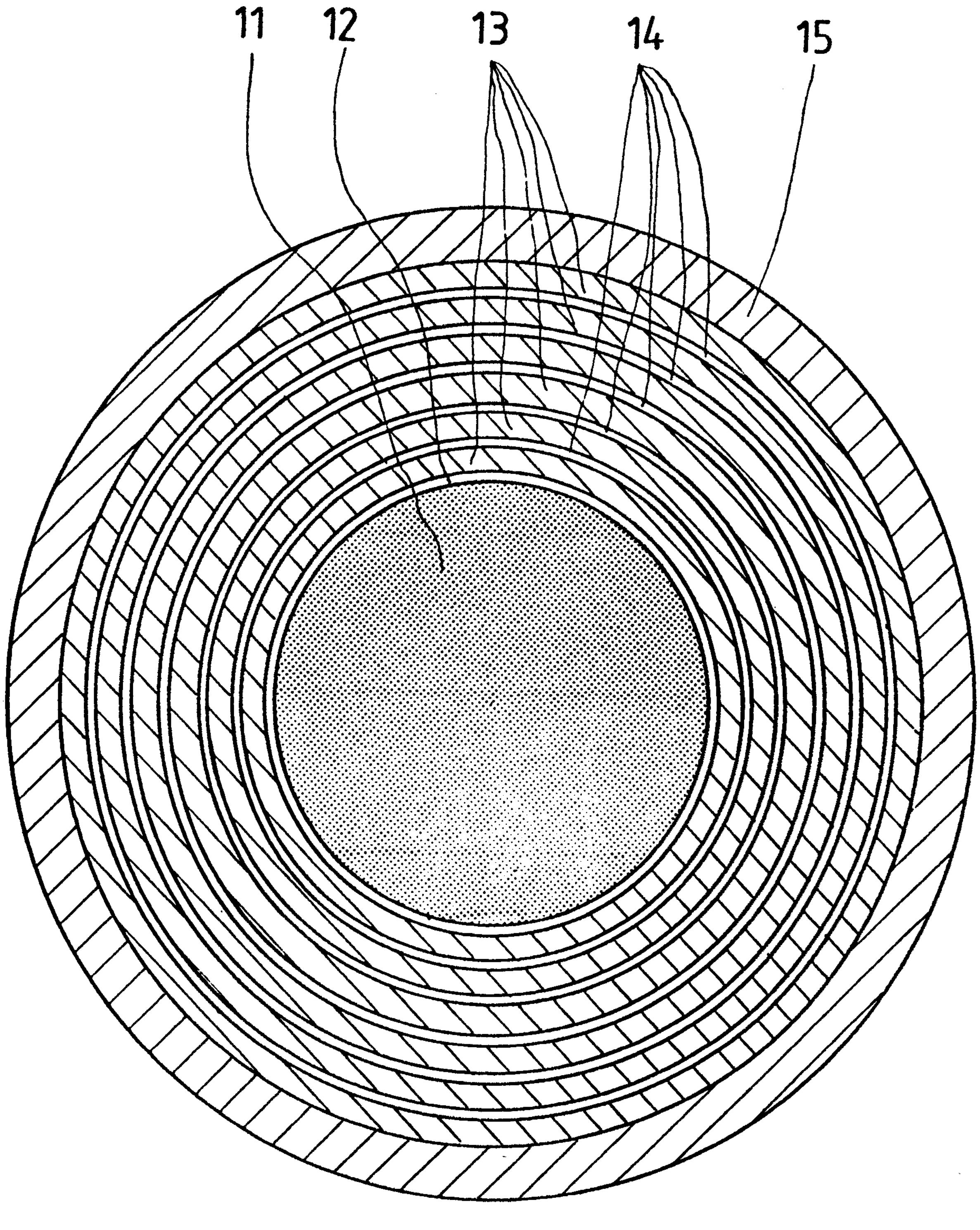


Fig. 1

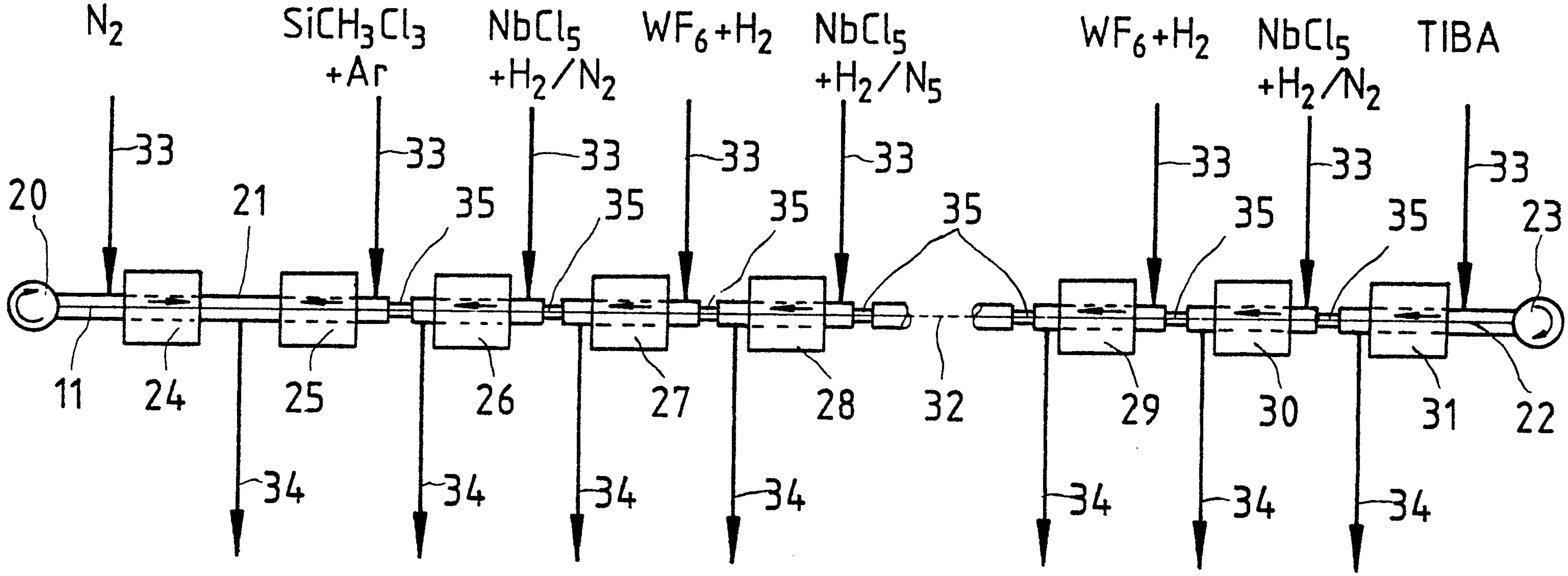

N2
SiCH3Cl3 +Ar
NbCl5 +H2/N2
WF6+H2
NbCl5 +H2/N5
WF6+H2
NbCl5 +H2/N2
TIBA
33
35
34
20
21
11
24
25
26
27
28
32
29
30
31
22
23


Fig. 2

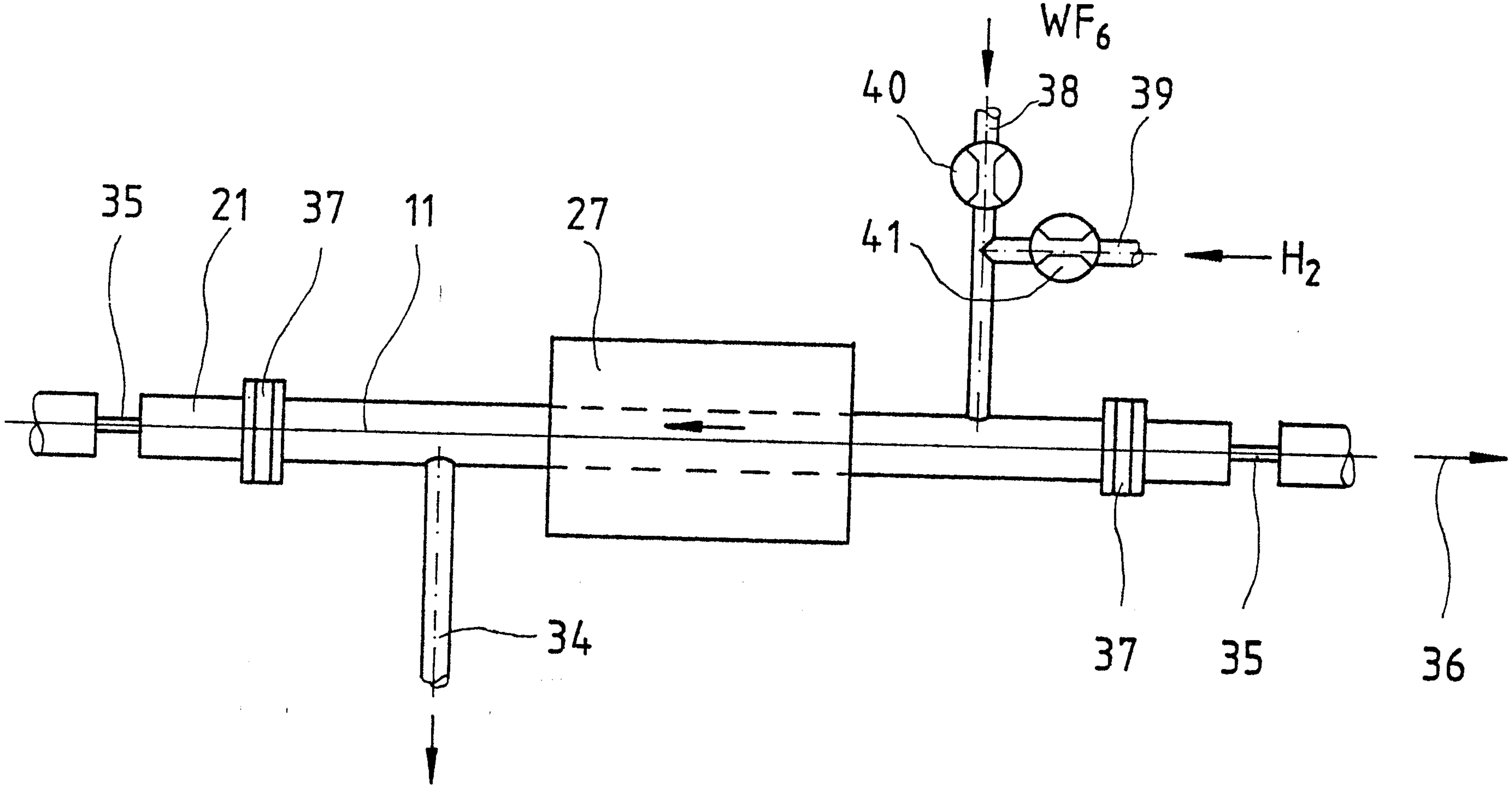


Fig. 3